(19) 

Europäisches
Patentamt
European
Patent Office
Office européen
des brevets

(11) **EP 2 757 383 A1**

(12) **EUROPEAN PATENT APPLICATION**
published in accordance with Art. 153(4) EPC

(43) Date of publication:
   **23.07.2014 Bulletin 2014/30**

(21) Application number: **12833771.4**

(22) Date of filing: **16.07.2012**

(51) Int Cl.:
   ***G01R 19/00*** (2006.01)     ***G01R 27/02*** (2006.01)
   ***G01R 31/00*** (2006.01)

(86) International application number:
   **PCT/CN2012/078721**

(87) International publication number:
   **WO 2013/040941 (28.03.2013 Gazette 2013/13)**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**

(30) Priority: **22.09.2011  CN 201110283676**

(71) Applicant: **ZTE Corporation
   Shenzhen, Guangdong 518057 (CN)**

(72) Inventors:
   • **XIONG, Yong
     Shenzhen, Guangdong 518057 (CN)**

• **XUE, Bing
   Shenzhen, Guangdong 518057 (CN)**
• **WANG, Di
   Shenzhen, Guangdong 518057 (CN)**

(74) Representative: **Mozzi, Matteo et al
   Jacobacci & Partners S.p.A.
   Via Senato, 8
   20121 Milano (IT)**

(54) **RECTIFIER IDENTIFICATION METHOD AND DEVICE**

(57)    A rectifier identification method includes: identifying a position of each rectifier using a voltage value detected by each rectifier connected to a pair of pre-added SVBs in a telecom DC power supply system, wherein precision resistors with same resistance value are connected in series at positions on an SVB bus which are corresponding to respective rectifiers, and two ends of the pair of SVB buses are respectively connected to positive and negative bars of DC output. Another rectifier identification method includes: identifying whether each rectifier is in place using a total resistance value detected by each rectifier connected to a pair of pre-added SRBs in a telecom DC power supply system, wherein precision resistors with different resistance values are connected in series at positions on an SRB bus which are corresponding to respective rectifiers, and when a rectifier is inserted into a socket, the precision resistor at the corresponding position on the SRB bus is short circuited. The method above can solve the problem that a large amount of resources are wasted and a large amount of space is occupied.

Using each rectifier connected to a pair of pre-added SVBs in a telecom DC power supply system to detect a corresponding voltage value, wherein precision resistors with same resistance value are connected in series at positions on an SVB bus which are corresponding to respective rectifiers, and two ends of the pair of SVB buses are respectively connected to positive and negative bars of DC output — S 102

Identifying a position of each rectifier according to the voltage value detected by the each rectifier — S 104

**Fig. 1**

# EP 2 757 383 A1

## Description

### Technical Field

The present invention relates to the field of communications, in particular to a rectifier identification method and device.

### Background

With the development of the technique of telecom power supply, more and more producers and users desire more intelligentized monitoring and rectifier of the power supply, and embedded systems, the cores of which are the microprocessor and Digital Signal Processor (DSP), are becoming more widely applied. Regarding telecom power supply, no matter a multi-rack large-system power supply, a single-rack base station power supply, an embedded power supply or a wall-mounted power supply, the basic component architectures of the power supply are the same: a mains supply or an oil engine is connected to an alternating power distribution unit, which divides and then transmits electric power to each parallel connected rectifier, the electric power is then converted into a 48 V direct current and is output to direct current distribution, to which all the loads and batteries are connected. In view of the application range and economy factors, the output capacity of a single rectifier is generally small, the specification thereof is 20 A, 30 A, 50 A, etc., and a power supply capability of 20 A to 800 A even more than 5000 A is provided by connecting a plurality of rectifiers in parallel.

Besides being parallel connected by positive and negative bars, respective rectifiers are usually connected with each other via a field bus such as a Controller Area Network (CAN) field bus or an RS485 field bus, to realize data interaction and load sharing with each other. The rectifiers can also conduct communication with a Control & Supervisory Unit (CSU) via the bus, to realize data collection of each rectifier, adjustment of the output voltage and current, and startup and shutdown control, etc. In this way, local area network communication of a field device level, which is generally in a master-slave management mode, that is, a monitor unit (referred to as a mater) monitoring other rectifiers (referred to as slaves), can be constructed.

When composing a field local area network of telecom power supply via a master-slave field bus, a device identifier is required to distinguish each rectifier or slave, and the commonly used method is taking the address as the identifier. Each rectifier has a unique address, thus enabling normal communication without incurring bus collisions. However, how to deal with the case where some rectifiers fail, rendering losing configuration addresses, or how to deal with the case where a certain rectifier is being repaired or is replaced, generating address collision, or how to deal with or configure the addresses in the case where some rectifiers are not configured successively, with some empty sockets therebetween, all need to be specified. Under the above cases, a unique address must be reconfigured to ensure normal communication. If the rectifier is equipped with a Dual In-line Package (DIP) switch or other human-computer interaction devices, such as a keyboard, a display, the address can be manually configured. In many cases, in consideration of costs and space, the rectifier does not have these interaction devices. This brings a very practical problem: during practical processing, how to configure the address of the rectifier conveniently and how to fast position the rectifier.

In order to fast position of the rectifier, the easiest method is to configure the addresses of rectifiers in turn according to the connection sequence of the field buses or according to the sequence of the sockets where these rectifiers are located. However, if some rectifier devices among all the rectifiers are pulled out and empty sockets appear, how to ensure that the addresses of the rectifiers are configured according to the connection sequence of the field buses or the sequence of the sockets where the rectifiers are located during the subsequent processing is still a problem.

A possible method currently employed is adding an additional input signal wire, i.e., a chip selection signal wire, to each rectifier, so that the address of each rectifier can be configured by monitoring. For example, the monitoring function first enables chip selection of a first rectifier and configures the address of this rectifier to be 1 (other rectifiers do not respond to the configuration command because the chip selection signal thereof is invalid); and so forth, the addresses of other rectifiers are configured. The method is relatively simple, but a plurality of signal wires should be added, and the number of the signal wires required to be added will also be very considerable, especially when the number of the rectifiers is very large, which wastes a large amount of resources and occupies a large space, making this method not applicable.

For the problem that a large amount of resources are wasted and a large space is occupied in related art, yet no effective solution is proposed at present.

### Summary

The present invention provides a rectifier identification method and device to at least solve the above-mentioned problem of wasting a large amount of resources and occupying large spaces.

According to an aspect of the present invention, a rectifier identification method is provided, including: using each rectifier connected to a pair of pre-added socket voltage buses (SVBs) in a telecom direct current (DC) power supply system to detect a corresponding voltage value, wherein precision resistors with same resistance value are connected in series at positions on an SVB bus which are corresponding to respective rectifiers, and two ends of the pair of SVB buses are respectively connected to positive and negative bars of DC output; and identifying a position of each rectifier according to the voltage value detected by the each rectifier.

Preferably, the pair of SVB buses is respectively defined as a public ground wire (SVB-G) and a voltage signal wire (SVB-V), wherein: the precision resistors with the same resistance value are connected in series at positions on the SVB-V which are corresponding to the respective rectifiers; and a busbar voltage is loaded on the SVB-V to form a loop via the series connected resistor array, generating an equal voltage drop.

Preferably, the voltage value detected by each rectifier is calculated according to the following formula: the voltage value detected on the Nth rectifier is: $(M-1)*V_0/M$; where M is an actual number of the resistors connected in series, and V0 is the busbar voltage.

Preferably, the method further includes: using each rectifier connected to a pair of pre-added socket resistance buses (SRBs) in the telecom DC power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and identifying whether each rectifier is in place according to the total resistance value of the SRB buses.

Preferably, the pair of SRB buses is respectively defined as an A wire (SRB-A) and a B wire (SRB-B), wherein: the precision resistors with different resistance values are connected in series at positions on the SRB-A which are corresponding to respective rectifiers; and the SRB-B is a terminal wire leading out from the resistor, which is located on the SRB-A at the corresponding position of the rectifier furthest from an end where a monitor is located.

Preferably, identifying whether each rectifier is in place according to the total resistance value of the SRB buses includes: determining an existing or effective resistor by comparing single resistors on the SRB bus one by one in sequence according to the actual impedance on the SRB bus, wherein the actual impedance of the resistors is the cumulative sum of respective existing or effective single resistors; and if a single resistor is determined to exist or to be effective, determining that the rectifier corresponding to the single resistor is not in place.

Preferably, a maximum detection deviation between each two precision resistors with different resistance values is calculated according to the following formula: $\Delta Rt = Rt \times (1 + P_R) \times (1 + P_{ADC}) - Rt$; where $\Delta Rt$ is the maximum detection deviation between each two precision resistors with different resistance values, Rt is a maximum impedance of a current resistor network, $P_R$ is precision of the used precision resistors, and $P_{ADC}$ is detection precision of an analogue-to-digital converter (ADC) adopted in a precision resistor and resistance value detection circuit.

Preferably, a minimum resistance value of the precision resistors with different resistance values satisfies the following formula: $Rt \times (1 - P_R) > (Rt - R1) \times (1 + P_R) + Rmax \times PA_{DC}$; where Rmax is a full scale of the current resistor network.

According to another aspect of the present invention, a rectifier identification method is provided, including: using each rectifier connected to a pair of pre-added socket resistance buses (SRBs) in a telecom direct current (DC) power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and identifying whether each rectifier is in place according to the total resistance value of the SRB buses.

According to still another aspect of the present invention, a rectifier identification device is provided, including: a first detection module, configured to use each rectifier connected to a pair of pre-added socket voltage buses (SVBs) in a telecom direct current (DC) power supply system to detect a corresponding voltage value, wherein precision resistors with same resistance value are connected in series at positions on an SVB bus which are corresponding to respective rectifiers, and two ends of the pair of SVB buses are respectively connected to positive and negative bars of DC output; and a first identification module, configured to identify a position of each rectifier according to the voltage value detected by the each rectifier.

According to still another aspect of the present invention, a rectifier identification device is provided, including: a second detection module, configured to use each rectifier connected to a pair of pre-added socket resistance buses (SRBs) in a telecom direct current (DC) power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and a second identification module, configured to identify whether each rectifier is in place according to the total resistance value of the SRB buses.

In the embodiment of the present invention, each rectifier connected to the pre-added SVB buses is used to detect a corresponding voltage value, and the position of each rectifier is identified according to the voltage value. Due to the voltage drops at different sockets, different rectifiers can detect different unique voltage amplitudes, based on which the position of each rectifier can be identified and the address information of each rectifier can be acquired. By means of the method provided in the embodiments of the present invention, there is no need to add a chip selection signal wire to each rectifier, and only one pair of SVB buses is added when there are a large amount of rectifiers, without occupying large space, and saving the resources.

**Brief Description of the Drawings**

Drawings, provided for further understanding of the present invention and forming a part of the specification, are used to explain the present invention together with embodiments of the present invention rather than to limit the present invention. In the drawings:

Fig. 1 is a flowchart showing the processing of a first rectifier identification method according to an embodiment of the present invention;
Fig. 2 is a flowchart showing the processing of a method of adding a pair of SRB buses according to an embodiment of the present invention;
Fig. 3 is a flowchart showing the identification on whether a rectifier is in place and the identification of rectifier addresses in sequence according to an embodiment of the present invention;
Fig. 4 is a flowchart showing the identification on whether a rectifier is in place according to an embodiment of the present invention;
Fig. 5 is a flowchart showing the identification of rectifier addresses in sequence according to an embodiment of the present invention;
Fig. 6 is a schematic diagram of a topology structure enabling the identification on whether a rectifier is in place and the identification of rectifier addresses in sequence according to an embodiment of the present invention;
Fig. 7 is a schematic diagram showing the backboard connection of telecom power supply buses according to an embodiment of the present invention;
Fig. 8 is a schematic diagram of a topology structure enabling the identification on whether a rectifier is in place and the identification of rectifier addresses in sequence according to embodiment 1 of the present invention;
Fig. 9 is a schematic diagram of a topology structure enabling the identification on whether a rectifier is in place according to embodiment 2 of the present invention;
Fig. 10 is a flowchart showing the processing of a second rectifier identification method according to an embodiment of the present invention;
Fig. 11 is a schematic structural diagram of a first rectifier identification device according to an embodiment of the present invention; and
Fig. 12 is a schematic structural diagram of a second rectifier identification device according to an embodiment of the present invention.

**Detailed Description of the Embodiments**

The present invention is described below with reference to the accompanying drawings and embodiments in detail. Note that, the embodiments of the present invention and the features of the embodiments can be combined with each other if there is no conflict.

It is mentioned in related art that an additional input signal wire, i.e., a chip selection signal wire, is added to each rectifier, so that the address of each rectifier can be configured by monitoring. For example, the monitoring function first enables chip selection of a first rectifier and configures the address of this rectifier to be 1 (other rectifiers do not respond to the configuration command because the chip selection signal thereof is invalid); and so forth, the addresses of other rectifiers are configured. The method is relatively simple, but a plurality of signal wires should be added, and the number of the signal wires required to be added will also be very considerable, especially when the number of the rectifiers is very large, which wastes a large amount of resources and occupies a large space, making this method not applicable.

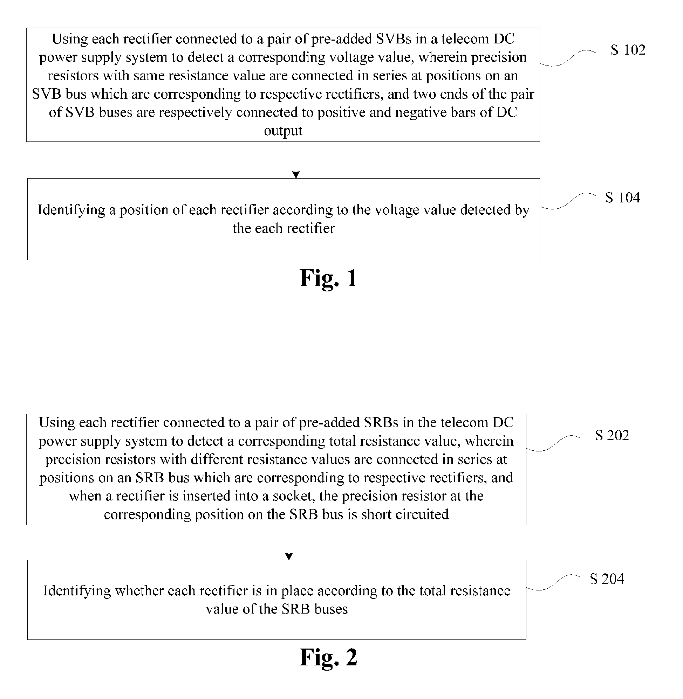

In order to solve the above-mentioned technical problem, a rectifier identification method is provided in an embodiment of the present invention. The processing flow of this rectifier identification method is as shown in Fig. 1, including the following steps S 102-S 104.

Step S102, each rectifier connected to a pair of pre-added SVBs (socket voltage buses) in a telecom DC power supply system is used to detect a corresponding voltage value, wherein precision resistors with same resistance value are connected in series at positions on an SVB bus which are corresponding to respective rectifiers, and two ends of the pair of SVB buses are respectively connected to positive and negative bars of DC output; and

Step S 104, a position of each rectifier is identified according to the voltage value detected by the each rectifier.

In the embodiment of the present invention, each rectifier connected to the pre-added SVB buses is used to detect a corresponding voltage value, and the position of each rectifier is identified according to the voltage value. Due to the voltage drops at different sockets, different rectifiers can detect different unique voltage amplitudes, based on which the position of each rectifier can be identified and the address information of each rectifier can be acquired. By means of the method provided in the embodiments of the present invention, there is no need to add a chip selection signal wire to each rectifier, and only one pair of SVB buses is added when there are a large amount of rectifiers, without occupying large space, and saving the resources.

During implementation, the SVB buses are respectively defined as a public ground wire (SVB-G) and a voltage signal wire (SVB-V), wherein: the precision resistors with the same resistance value are connected in series at positions on the SVB-V which are corresponding to the respective rectifiers; and a busbar voltage is loaded on the SVB-V to form a loop via the series connected resistor array, generating an equal voltage drop. In each loop, the voltage value detected by each rectifier may be calculated according to the following formula: the voltage value detected on the Nth rectifier is: $(M-1)*V_0/M$; where M is an actual number of the resistors connected in series, and $V_0$ is the busbar voltage.

In an embodiment of the present invention, when some rectifiers cannot communicate with the monitor unit, if these rectifiers are inserted into or exist in the socket, the system can report an alarm indicating "communication interrupt at No. XX rectifier"; however, if the socket is empty and the rectifier does not exist, there is no need to report this alarm. The problem is how a system learns whether there is a rectifier on the socket, in other words, how does the system acquire an in-place signal of the rectifier.

A possible method is provided in the related art, that is, two additional passive input wires are added to each rectifier. Usually, the two wires are disconnected, and when a rectifier is inserted, the rectifier physically short circuits the two wires directly. In this way, the monitor unit can judge whether there is a rectifier at the socket by detecting whether the two wires are disconnected. This method is relatively simple, but requires adding a large amount of signal wires. For example, even a wire therein is common, for a telecom power supply configured with 20 rectifiers, at least 21 signal wires are required, which amount is too large and not appropriate in most occasions.

In order to solve the problem that adding passive input wires is not appropriate due to the considerable amount of input wires when a large number of rectifiers is presented, a method for solving this problem is provided in an embodiment of the present invention, referring to Fig. 2.

Step S202, each rectifier connected to a pair of pre-added SRBs (socket resistance buses) in a telecom DC power supply system is used to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and

Step S204, it is identified whether each rectifier is in place according to the total resistance value of the SRB buses.

The pair of SRB buses are respectively defined as an A wire (SRB-A) and a B wire (SRB-B), wherein: the precision resistors with different resistance values are connected in series at positions on the SRB-A which are corresponding to respective rectifiers; and the SRB-B is a terminal wire leading out from the resistor, which is located on the SRB-A at the corresponding position of the rectifier furthest from an end where a monitor is located.

Adopting the flow shown in Fig. 2, during the subsequent processing, an existing or effective resistor can be determined by comparing single resistors on the SRB bus one by one in sequence according to the actual impedance on the SRB bus, wherein the actual impedance of the resistors is the cumulative sum of respective existing or effective single resistors; and if a single resistor is determined to exist or to be effective, it is determined that the rectifier corresponding to the single resistor is not in place.

During implementation, a maximum detection deviation between each two precision resistors with different resistance values is calculated according to the following formula: $\Delta Rt = Rt \times (1 + P_R) \times (1 + P_{ADC}) - Rt$; where $\Delta Rt$ is the maximum detection deviation between each two precision resistors with different resistance values, Rt is a maximum impedance of a current resistor network, $P_R$ is precision of the used precision resistors, and $P_{ADC}$ is detection precision of an analogue-to-digital converter (ADC) adopted in a precision resistor and resistance value detection circuit.

In addition, on condition that the maximum detection deviation is determined, a minimum resistance value of the precision resistors with different resistance values should satisfy the following formula: $Rt \times (1 - P_R) > (Rt - R1) \times (1 + P_R) + Rmax \times P_{ADC}$; where Rmax is a full scale of the current resistor network.

It can be seen from the technical solution combining Fig. 1 and Fig. 2 that, in an embodiment of the present invention, two pairs of signal buses are added among field buses of a telecom DC power supply system. One pair of signal buses is used for detecting an in-place signal of a rectifier, referred to as SRB buses; and the other pair of signal buses is used for detecting an address signal of the rectifier, referred to as SVB buses. At the positions on the two pairs of buses corresponding to respective rectifiers, precision resistors are connected in series. Resistors with different resistance values selected carefully are used on the SRB buses; and resistors with the same resistance value are used on the SVB buses. The two ends of the SVB buses are respectively connected to the positive and negative bars of DC output. When a rectifier is inserted into a socket, the precision resistor at the corresponding position on the SRB bus is short circuited, so that the monitor unit can identify which rectifier is in place (i.e., inserted into the socket) by detecting the total resistor of the SRB bus; moreover, each rectifier and the monitor unit respectively detect the voltage value on the SVB to determine the address of the rectifier (e.g., the socket in which the rectifier is located).

A key point of the rectifier identification method provided by the embodiment of the present invention lies in that: firstly the two pairs of signal buses are newly added, and precision resistors are connected in series on the two pairs of signal buses; secondly, a DC output voltage is loaded on the SVB bus, and according to the resistive dividing voltages on different sockets, different rectifiers can detect different unique voltage amplitudes, which is the key to successfully learn and configure the addresses of the rectifiers; and thirdly, there are resistors with different resistance values carefully selected at different sockets on the SRB bus, and this is the key to the in-place signal of the rectifier.

The embodiment of the present invention can solve the problem that in the field bus network of a telecom DC power supply, the loss of the rectifier address may result in collision or identifier error, and the problem that the in-place signal of the rectifier cannot be identified or a large amount of wiring is required, which can not be applied during engineering application. In order to solve the above-mentioned technical problems, an embodiment of the present invention provides a reliable universal solution, which can solve the above-mentioned problems by means of series wiring of precision resistors without adding many transmission signal wires and much hardware. This solution can accomplish the identification of the in-place signal of each rectifier and the reconfiguration and identification of the addresses, further, the solution can perfectly match an address and a socket of the device, which ensures the normal communication of the field buses.

Compared with the solution in related art, the advantages of the rectifier identification method provided in the embodiments of the present invention lie in that, all of the above-mentioned problems can be solved by means of series wiring of precision resistors without adding many transmission signal wires and much hardware, which is very suitable for engineering application.

The purpose, principle and technical solution of the rectifier identification method provided in the embodiments of the present invention are briefly introduced, and the steps to realize the method will be described in detail bellow.

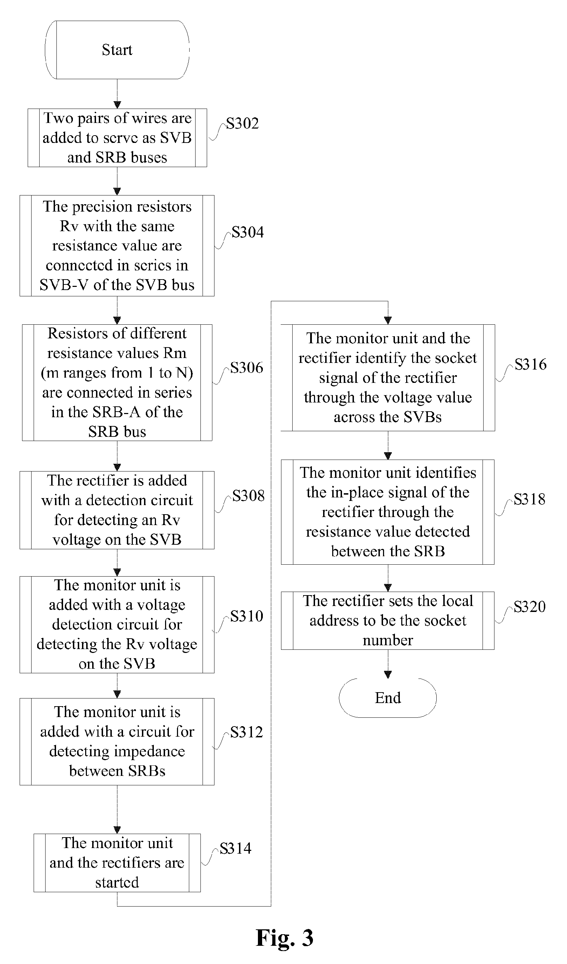

Brief description is made to each step; for the specific flow please refer to Fig. 3, the flow includes the following steps:

step S302, two pairs of wires are added, serving as SVB and SRB buses;
step S304, precision resistors Rv with the same resistance value are connected in series in the SVB-V of the SVB buses;
step S306, precision resistors of different resistance values Rm (m varies from 1 to N) are connected in series in the SRB-A of the SRB buses;
step S308, the rectifier is added with a voltage detection circuit for detecting the Rv voltage on the SVB;
step S310, the monitor unit is added with a voltage detection circuit for detecting the Rv voltage on the SVB;
step S312, the monitor unit is added with a circuit for detecting an impedance between SRBs;
step S314, the monitor unit and the rectifiers are started;
step 316, the monitor unit and the rectifier identify the socket signal of the rectifier through the voltage value across the SVBs;
step S318, the monitor unit identifies the in-place signal of the rectifier through the resistance value detected between the SRB; and
step S320, the rectifier sets the local address to be the socket number.

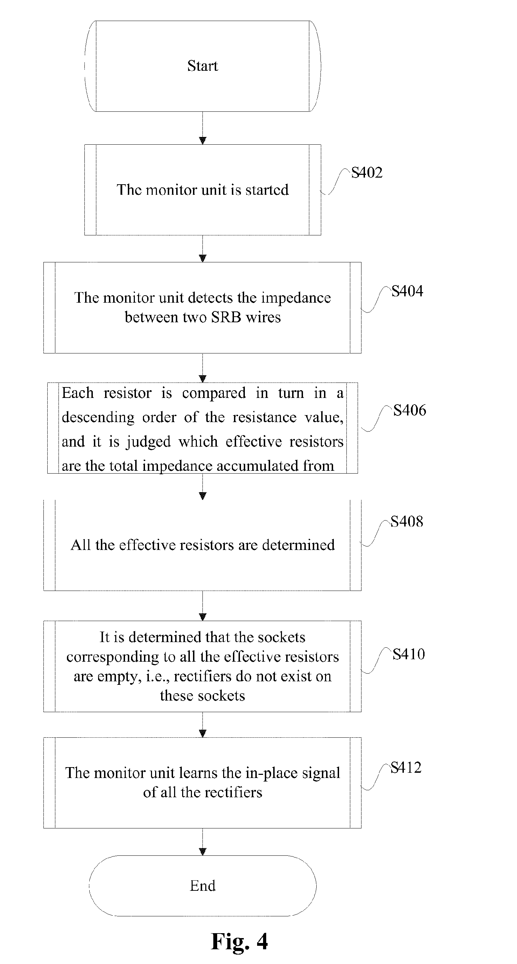

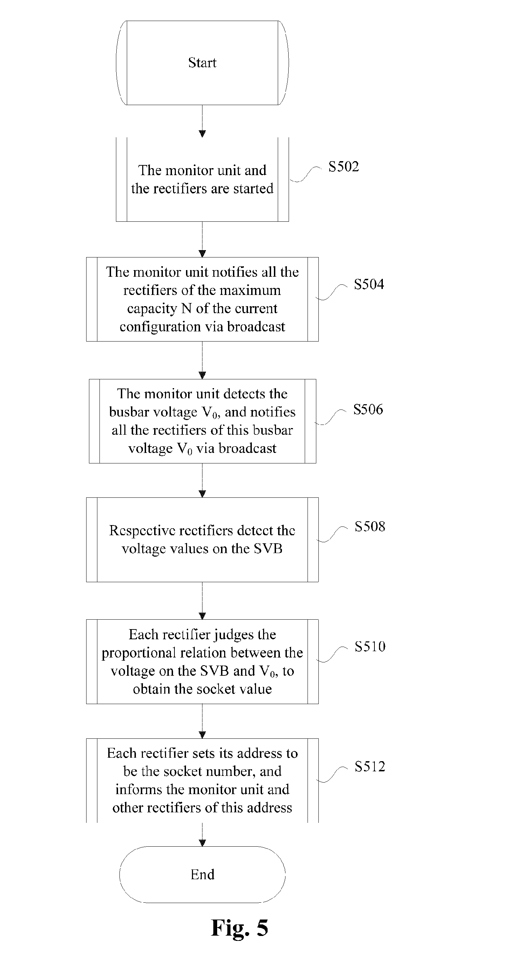

It can be seen from Fig. 3 that the identification of the rectifier includes two types of identification methods of in-place identification and address sequence identification. Description will be respectively made to each identification method, and for the processing flows, please respectively refer to Fig. 4 and Fig. 5. Fig. 4 is the flowchart of the in-place identification of the rectifier, including:

step S402, the monitor unit is started;
step S404, the monitor unit detects the impedance between two SRB wires;
step S406, each resistor is compared in turn in a descending order of the resistance value, and it is judged which effective resistors are the total impedance accumulated from;
step S408, all the effective resistors are determined;
step S410, it is determined that the sockets corresponding to all the effective resistors are empty, i.e., rectifiers do not exist on these sockets;
step S412, the monitor unit learns the in-place signal of all the rectifiers.

Fig. 5 is the flowchart of the identification of rectifier addresses in sequence, including:

step S502, the monitor unit and the rectifiers are started;

step S504, the monitor unit notifies all the rectifiers of the maximum capacity N of the current configuration via broadcast;

step S506, the monitor unit detects the busbar voltage $V_0$, and notifies all the rectifiers of this busbar voltage $V_0$ via broadcast;

step S508, respective rectifiers detect the voltage values on the SVB;

step S510, each rectifier judges the proportional relation between the voltage on the SVB and $V_0$, to obtain the socket value;

step S512, each rectifier sets its address to be the socket number, and informs the monitor unit and other rectifiers of this address.

Fig. 3 and Fig. 5 show the flow of the in-place and address sequence identification of a rectifier, and detailed description is made to the specific implementation.

The first step is to construct a field bus network, including choosing wire and devices, designing a circuit, engineering application, etc.

The communication wires of the field bus usually adopt economic twisted-pair. In this embodiment, two pairs of wires need to be added to deliver SRB and SVB signals. There is not special requirements for the two pairs of wires, they can be ordinary wires and of course can be twisted-pairs. If the field bus uses the RS485 bus or CAN bus, the physical connection requires one pair of twisted-pair, then twisted-pairs of at least 6 wires (3 pairs) should be used; when the number of the configured rectifiers is not too large, it is recommended to use the type 5 twisted-pair (8 wires) of the Ethernet, which is universal and economic.

The maximum amount (socket amount) of the rectifiers configured in the system is defined to be N. The field bus wiring adopts the series address (socket) allocation method, wherein the monitor is located at one end of the bus, closest to the monitor is the rectifier with address 1, other rectifiers are connected successively, and the rectifier furthest from the monitor is connected in series at the end of the bus, with the address of N.

The usage of the field communication bus is not changed. The field communication bus is used for performing normal communication between the monitor and the rectifier to implement the monitoring of the system.

The newly added SVB buses are used for series connecting the monitor and the rectifiers, and this pair of SVB buses are respectively defined as a common ground wire SVB-G and a voltage signal wire SVB-V. Precision resistors Rv of the same resistance value are connected in series at the positions on the SVB-V which are corresponding to respective rectifiers; the busbar voltage loaded on the SVB-V passes through the series connected resistor array and forms a loop, generating an equal voltage drop. Therefore, the rectifiers on respective sockets can detect different voltage values and determine different sockets through the different voltage values, in this way, a device address matching the socket can be configured.

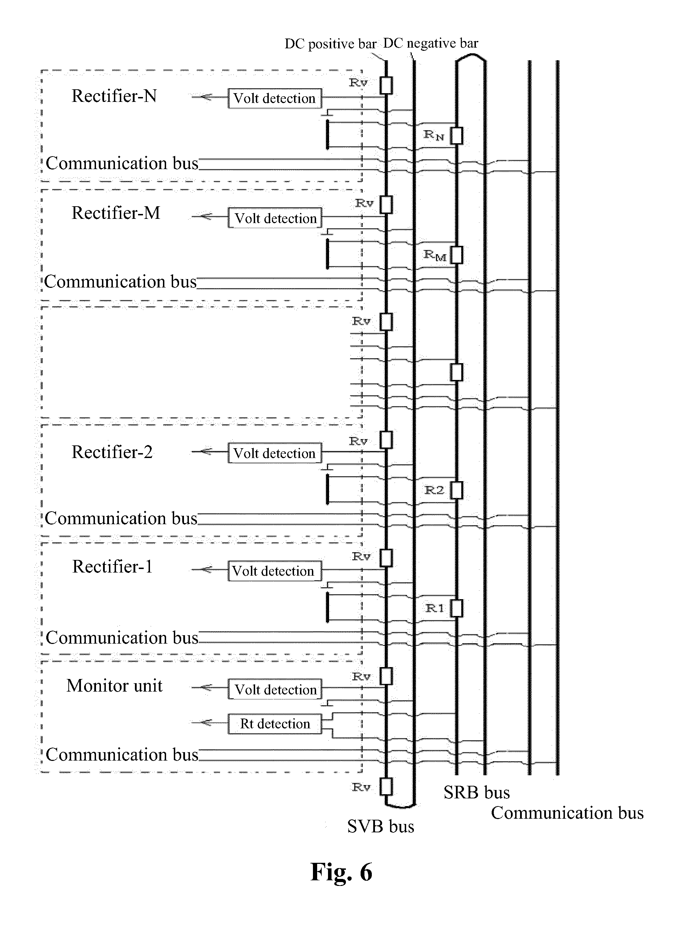

The newly added SRB buses are used for series connecting the monitor and the rectifiers, and this pair of SRB buses are respectively defined as an A wire SRB-A and a B wire SRB-B. According to the maximum amount of the rectifiers configured by the system, precision resistors, e.g., resistors R1, R2 to RN, are connected in series at the positions on the SRB-A which are corresponding to respective rectifiers, wherein the resistance value of R1 is the minimum, and the resistance value of RN is the maximum (alternatively, the resistance value of R1 is the maximum, and the resistance value of RN is the minimum). A terminal wire leading out from the resistor, which is located on the SRB-A at the corresponding position of a furthest rectifier N is the SRB-B wire. The schematic diagram showing the topology structure for implementing the in-place identification and the sequence address identification of the rectifier after the SVB buses and SRB buses are added is as shown in Fig. 6.

A voltage detection circuit is added to each rectifier to detect the Rv voltage value on the SVB-V corresponding to the current socket;

the monitor is also added with a voltage detection circuit to detect the busbar voltage, and the corresponding Rv voltage value on the SVB; and

the monitor is also added with a resistance value detection circuit to detect the total impedance between the SRB buses.

The second step is to automatically identify and configure an address by the rectifier and to correspond the address to the socket by means of the following steps after the monitor and the rectifiers are started.

The monitor sends broadcast information through an existing field communication bus, such as CAN, RS485, to inform all the rectifiers of the maximum number N of the rectifiers configured in the current system.

The monitor detects the busbar voltage $V_0$ through the newly added voltage detection circuit (if the original circuit has this function, this voltage detection circuit is not required to be added), and sends broadcast information through the communication bus such as CAN or RS485 to inform all the rectifiers of the numerical value of $V_0$. The current step is not necessary, if the rectifier can detect the busbar voltage $V_0$, this step can be omitted.

Each rectifier detects the voltage value on the corresponding Rv on the SVB bus through the newly added voltage detection circuit.

Since the used resistors are all highly precise resistors with the same resistance value, each rectifier can obtain the socket by judging the numerical proportional relation between the voltage on the SVB and $V_0$. It is assumed that the total amount of resistors is M (since the monitor unit will also be configured with one or more resistors to detect the voltage, the actual number of resistors connected in series is more than N, in the Fig. 1, M = N + 2), it can be obtained that the voltage detected by the first rectifier is $2*V_0/M$; the voltage detected by the monitor unit is $V_0/M$; and so forth, the voltage detected by the last but one rectifier is $(M-2) \times V_0/M$; and the voltage detected by the last rectifier is $(M-1)*V_0/M$.

Each rectifier configures the address of itself to be the socket as obtained and informs the monitor and other rectifiers of this information.

The third step is to identify which sockets are inserted with rectifiers (once a rectifier is inserted, the resistor of the corresponding socket on the SRB will be short circuited) by detecting the total impedance on the SRB bus, after the monitor is started. In this way, the in-place signals of all the rectifiers can be acquired.

The monitor first carefully selects and configures the precision resistors connected on the SRB bus according to the measurement range of the newly added circuit for detecting the resistance value.

The monitor detects the actual impedance of the SRB bus by the circuit for detecting the resistance value.

According to the actual impedance on the SRB bus, respective single resistors on the SRB bus are compared one by one in a descending order of the resistance value, i.e. starting from RN to R1, so as to determine which resistor(s) among R1~ RN exists or is effective, that is, to verify which resistance values among R1~RN is the actual impedance accumulated from. The monitor can judge which socket has a rectifier and which socket does not have a rectifier by determining that the rectifier is not in place at the position corresponding to an existing or effective resistor among R1~RN, and in this way, all the in-place signals can be identified.

It is mentioned above that the resistance values of respective precision resistors on the SRB bus are different, therefore, how to select the resistance values of the precision resistors on the SRB bus is an important problem. In the embodiments of the present invention, several key algorithms are used to select the resistance values of the precision resistors on the SRB bus, so that in the situation where certain rectifier(s) is inserted into socket(s), the monitor can detect a unique actual resistance value different from that of any other situations on the SRB bus. The preferred processing method is described as follows.

First of all, the precision and range of the precision resistors in the circuit and that of the ADC in the resistance value detection circuit are determined.

The precision of the used precision resistors (with small tolerance and stable the resistance value) is defined to be $P_R$. The $P_R$ of precision resistors commonly used in engineering application are 0.1%, 0.05% or even 0.01 %.

The full scale of the precision resistor network is defined to be Rmax; the detection precision of the ADC is defined to be $P_{ADC}$, commonly being 1/1024 (10-bit precision, about 0.1%), higher ones being 1/4096 (12-bit precision, about 0.025%), or even 16 bits and 24 bits.

In the precision resistor network, the N resistors configured in an ascending order are defined to be the first resistor $R_1$, the second resistor $R_2$, ......, and the Nth resistor $R_N$. The total impedance is $Rt = R_1 + R_2 + ...+ R_N = \Sigma Ri$. Apparently, Rt should be less than Rmax.

Secondly, the minimum difference value ΔR between each two resistors is determined.

In order to ensure that all the resistors $R_1$, $R_2$, ..., $R_{N-1}$, $R_N$ can be correctly identified, it is required that each resistance value is unique. Assuming that the minimum resistance difference value between each two resistor is ΔR, then:

$$R_2 > R_1 + \triangle R$$

$$R_3 > R_2 + \triangle R$$

$$...$$

$$RN > RN\text{-}1 + \triangle R$$

In order to ensure that any combination of R1, R2, ..., RN-1, RN can be correctly identified, the resistance values should satisfy the following correlations:

$$R2 > R1 + \triangle R$$

$$R3 > ( R1 + R2 ) + \triangle R$$

$$R4 > ( R1 + R2 + R3 ) + \triangle R$$

$$\dots$$

$$RN > \sum Ri \text{ (i ranging from 1 to N-1)} + \triangle R$$

Since the maximum impedance of the network detected by the resistance value detection circuit is $Rt \times (1 + P_R) \times (1 + P_{ADC})$, the maximum deviation of the detected resistance value is $\Delta Rt = Rt \times ( 1 + P_R) \times ( 1 + P_{ADC}) - Rt$.
Assuming that the full scale of the detection circuit is Rmax = 200 KΩ, Rt < 200 KΩ, $P_R$ is 0.1% and $P_{ADC}$ is 1/1024 (about 0.1%), then the maximum value of ΔRt is about 200 Ω. In order to ensure that the ADC can make distinction correctly (by at least one quantized value), $\Delta R > \Delta Rt + Rmax \times P_{ADC}$ should be satisfied, so it can be obtained by calculation that ΔR> 400Ω.
Then, the minimum value of the first resistor R1 is determined.
Apparently, if the resistance value detection circuit can detect the most special situation, it is able to detect other situations where any one or more resistors are short circuited, wherein the special situation is: when the total impedance Rt has the maximum negative deviation, it can still be larger than the remaining resistance value after R1 is short circuited having the maximum positive deviation, by at least one quantized value. That is,

$$Rt \times (1 - P_R) > (Rt - Rl) \times (1 + P_R) + Rmax \times P_{ADC}$$

According to the value as assumed before, R1 > 600 Ω should be satisfied.
Further, the theoretical resistance values of all the resistors are determined.
In order to achieve an N value as large as possible (i.e. the number of the rectifiers of the system supported is as large as possible), apparently, it is desired that ΔR is as small as possible and R1 is as small as possible (although the value of R1 does not have much influence on the value of N).
In each of the above-mentioned example steps, Rt is simplified to be equal to Rmax for calculation, apparently, the calculated ΔR and R1 are relatively large under such circumstance, however, a larger redundancy can be obtained in this way which makes it safer in engineering application. These safety values of R1 = 600 Ω and ΔR = 400 Ω are used to determine all the resistors:

$$R1 = 600 \ \Omega,$$

$$R2 = R1 + \triangle R = 1 \ K\Omega$$

$$R3 = ( R1 + R2 ) + \triangle R = 2 \ K\Omega$$

$$R4 = \dots\dots = 4 \ K\Omega$$

$$R5 = \ldots\ldots = 8 \ K\Omega$$

$$R6 = \ldots\ldots = 16 \ K\Omega$$

$$R7 = \ldots\ldots = 32 \ K\Omega$$

$$R8 = \ldots\ldots = 64 \ K\Omega$$

$$R9 = \ldots\ldots = 128 \ K\Omega$$

Apparently, the resistors that can be chosen are only R1, R2, ..., up to R8.

Rt = ΣRi (i ranging from 1 to 8) = 127.6 KΩ < 200 KΩ = Rmax; while ΣRi (i ranging from 1 to 9) is larger than Rmax, which does not satisfy the condition that the total impedance does not exceed Rmax.

In other words, under the condition of the precision of the precision resistors and the detection precision, the number of the rectifiers that can be supported is N = 8.

Of course, there are other values satisfying the conditions, for example, when R1 = 1 KΩ and ΔR = 500 Ω, the resistance values of the resistors may be:

$$R1 = 1 \ K\Omega,$$

$$R2 = R1 + \triangle R = 1.5 \ K\Omega$$

$$R3 = (\ R1 + R2\ ) + \triangle R = 3 \ K\Omega$$

$$R4 = \ldots\ldots = 6 \ K\Omega$$

$$R5 = \ldots\ldots = 12 \ K\Omega$$

$$R6 = \ldots\ldots = 24 \ K\Omega$$

$$R7 = \ldots\ldots = 48 \ K\Omega$$

$$R8 = \ldots\ldots = 96 \ K\Omega$$

$$\sum \text{Ri (i ranging from 1 to 8)} = 191.5 \text{ K}\Omega < 200 \text{ K}\Omega = \text{Rmax.}$$

It can also be obtained from theoretical analysis that the value of N is 8 in the current embodiment. Because the ADC with 10-bit precision and resistors with 0.1% precision are used in this embodiment, the value ofN can only be 9 at most in theory. In view of the reliability of engineering application, the number N is selected to be 8 at most.

The above two sets of resistance values are both applicable. Apparently, by comparison, the second set of values under R1 = 1KΩ and ΔR = 500 Ω has better adaptability to interference and error, and is more suitable for engineering application. Hence, as a preferable embodiment, it is recommended to choose R1 and ΔR as large as possible on the premise that the conditions are satisfied. After R1 and ΔR are determined, the next step is to determine the resistance values of the resistors in the engineering application.

The engineering resistance values of all the resistors are determined.

What are obtained in the step of "determining the theoretical resistance values of all the resistors" are theoretical values. For the convenience of engineering application, standard resistance values commonly used are selected. There are two ways to determine the engineering resistance values of resistors: the first one is a value check method; and the second one is fast dimidiation backward induction method.

The specific processing method when using the value check method is described as follows.

Description is made by referring to the example regarding the step of "determining the theoretical resistance values of all the resistors". The second choice is: R1 = 1 KΩ, R2 = 1.5 KΩ, R3 = 3 KΩ, R4 = 6 KΩ, R5 = 12 KΩ, R6 = 24 KΩ, R7 = 48 KΩ and R8 = 96 KΩ.

The selected standard resistance values are as follows:

1 KΩ, 1.5 KΩ, 3 KΩ, 6 KΩ, 12 KΩ and 24 KΩ among the above instance values are commonly used resistance values, but 48 KΩ and 96 KΩ are not standard instance values; therefore, tiny adjustment is made to select resistance values of 48.1 KΩ and 100 KΩ commonly used in engineering.

Whether the 8 resistance values of 1 KΩ, 1.5 KΩ, 3 KΩ, 6 KΩ, 12 KΩ, 24 KΩ, 48.1 KΩ and 100 KΩ satisfy the conditions are checked (since tiny adjustment is made). Upon checking, all the resistance values selected satisfy the formulae, therefore are suitable for the engineering application.

If the selected resistors do not satisfy the formulae, tiny adjustment is further made.

If the adjustment does not work, the values of R1 and ΔR are changed.

If the values cannot be changed indeed, the ultimate solution is to connect a plurality of resistors in series or in parallel to approximate the theoretical value.

The specific processing method when using the fast dimidiation backward induction method is described as follows.

The values are determined by dimidiation starting from the maximum resistance and conducting downward adjustment to the engineering values.

Description is made by referring to the same example as well, since Rmax = 200 KΩ, the resistance values are determined in the following manner:

the value of the maximum resistor R8 is a half of Rmax, i.e., 100 KΩ, and adjustment is not required since this resistance value is a standard resistance value;

R7, taking a half of the value of R8, i.e., 50 KΩ, and adjustment is not required since this resistance value is a standard resistance value;

R6, taking a half of the value of R7, i.e., 25 KΩ, and the value is adjusted to the minimum deviation value, i.e., 24.9 KΩ since 25KΩ is not a standard resistance value;

R5, taking a half of the value of R6, i.e., 12.45 KΩ, and the value is adjusted to the minimum deviation value, i.e., 12.4 KΩ since 12.45KΩ is not a standard resistance value;

R4, taking a half of the value of R5, i.e., 6.2 KΩ, and the value is adjusted to the minimum deviation value, i.e., 6.19 KΩ since 6.2KΩ is not a standard resistance value;

R3, taking a half of the value of R4, i.e., 3.095 KΩ, and the value is adjusted to the minimum deviation value, i.e., 3 KΩ since 3.095KΩ is not a standard resistance value;

R2, taking a half of the value of R3, i.e., 1.5 KΩ, and adjustment is not required since this resistance value is a standard resistance value;

R1, taking a half of the value of R2, i.e., 0.75 KΩ, and adjustment is not required since this resistance value is a standard resistance value.

In this way, there are 8 resistance values of 0.75 KΩ, 1.5 KΩ, 3 KΩ, 6.19 KΩ, 12.4 KΩ, 24.9 KΩ, 50 KΩ and 100 KΩ. Upon checking, all the resistance values selected satisfy the formulae, therefore are suitable for the engineering application. Of course, if 6.19 KΩ, 12.4 KΩ and 24.9 KΩ are adjusted to more common resistance values such as 6 KΩ, 12 KΩ and 24 KΩ, it is verified that they also satisfy the formulae. Therefore, the 8 resistance values of 0.75 KΩ, 1.5 KΩ, 3 KΩ, 6 KΩ, 12 KΩ, 24 KΩ, 50 KΩ and 100 KΩ may be selected. Upon verification, the total resistance value of the 8 resistors is 197.5 KΩ, and 197.5 KΩ × 1.001 × 1.001 = 197.89 KΩ, which is smaller than the full scale of 200 KΩ.

The principle for selection of the resistors is that: under the condition that all of the above-mentioned formulae are satisfied, the value of Rt is selected to be as large as possible (approximating the full scale Rmax of the detection resistor), and the values of R1 and ΔR are also as large as possible, which can guarantee better adaptability to interference and error and is more suitable for engineering application.

By means of the method provided in the embodiments of the present invention, the above-mentioned problems can be solved by means of series wiring of precision resistors without adding many transmission signal wires and much hardware. This solution can accomplish the identification of the in-place signal of each rectifier and the reconfiguration and identification of the addresses, further, the solution can perfectly match an address and a socket of the device, which ensures the normal communication of the field buses and reduces the workload for product maintenance. At the same time, the intelligentized management to the network by the monitor is also improved.

The implementation of the technical solution is further described in detail in combination with the drawings.

Embodiment 1

A certain company produces a telecom embedded power supply system of a certain model, which is widely used among various telecommunication device manufactures and operators throughout the country. The power supply system is composed of alternating current distribution, direct current distribution, at most 8 rectifiers and one monitor unit. Due to the power density requirement, cost pressure and the requirement of plug-and-play, besides the alarm indicator light and the CAN interface, the rectifier does not have any other human-computer interaction device. Therefore, the monitor unit is required to communicate with the 8 rectifiers through the CAN bus, and distinguish and identify each rectifier through the address, so that the monitor unit acquires the data and alarm information related to each rectifier in a polling manner, and controls the operation status of each rectifier.

In the previous implementation, respective rectifiers compete for an address via the CAN bus, so the address can be arbitrarily configured to be 1~8. It is apparent that there is little chance for the address of a rectifier to completely correspond to the socket where the rectifier is located; and this usually confuses field maintenance personnel. Besides, when the number of the rectifiers configured in the system increases or decreases or when a rectifier restarts, the address competition happens again, resulting in the change of the addresses, which also brings great trouble to the query of history record (including history data and history alarm), etc. At the same time, since CAN communication interruption of a rectifier often appears in practical application, it is difficult to judge whether the rectifier is not configured at all or the communication interruption is resulted from software or hardware reasons after the rectifier is configured. If the common in-place signal identification solution is adopted, for the 8 rectifiers, at least 8 signal wires (not including at least one common wire) needs to be added, which is very complicated for wiring and wires.. When the system is composed of more rectifiers, there will be more wiring and wires required, which is substantially impossible; and this is also the technical difficulty not well solved by current domestic power supply producers.

The specific steps of the rectifier identification method in the embodiments of the present invention are described as follows.

I. Hardware implementation steps

Regarding wire selection, since the CAN bus is used between the master and slave data, only one pair of wires are required. Therefore, two pairs of wires respectively serving as the SVB/SRB buses are added. In the embodiment of the present invention, the Ethernet wire T568A/B (containing 4 twisted pairs marked by colours) of common used 10/100 BASE-T is used, and the adopted connector is a matched RJ45.

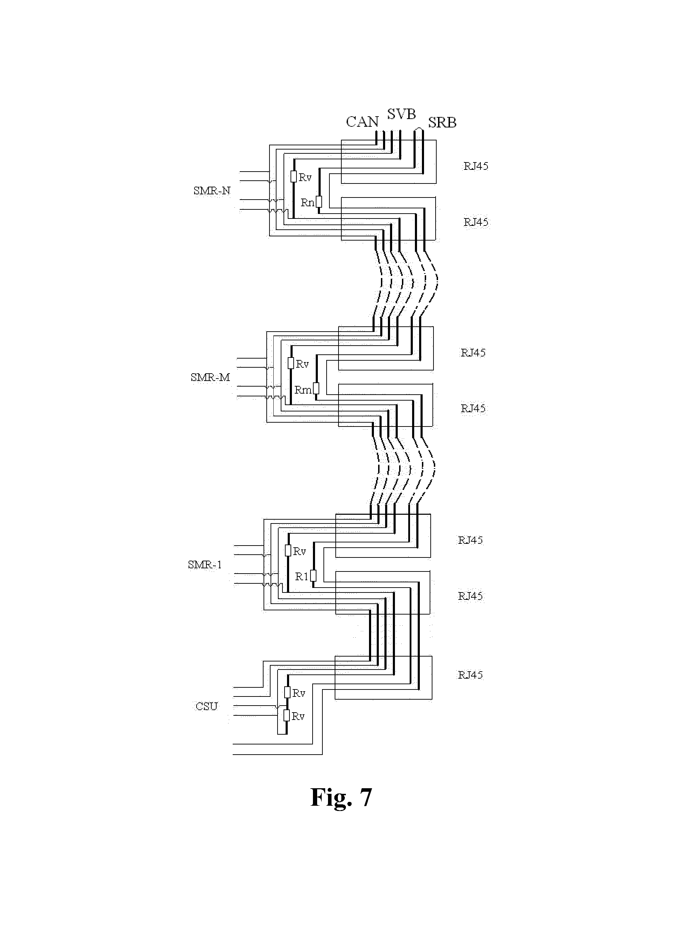

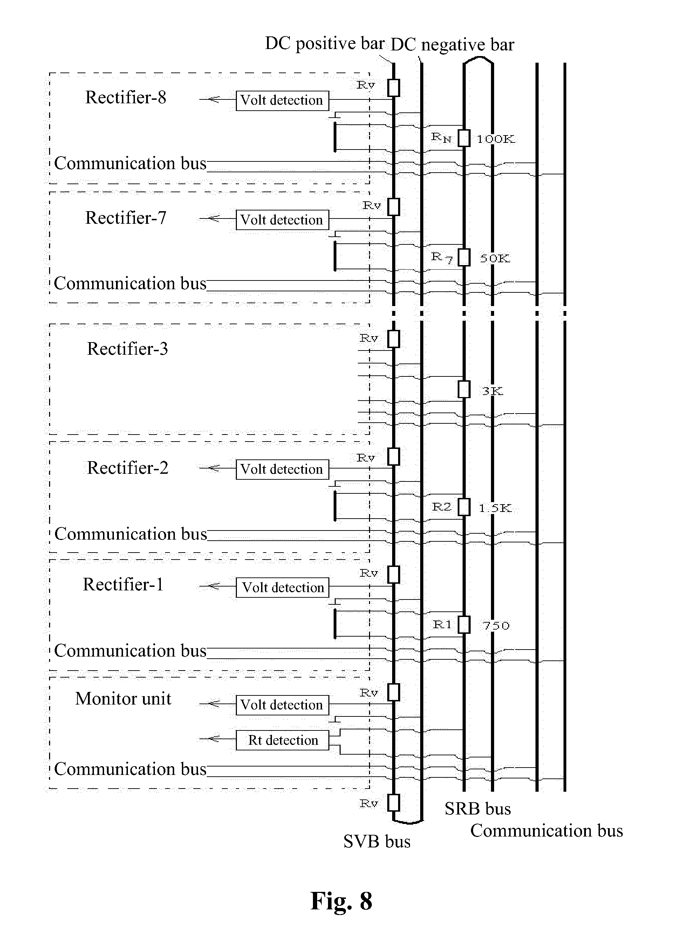

Regarding network connection, in order to connect the monitor unit and each rectifier and to allocate the address of each rectifier, the elements should be connected in series via a network cable successively. With respect to wiring, it is ensured that the monitor unit is located at one end, and then respective rectifiers are connected in series successively, with the rectifier in the furthest socket located at the other end of the network cable (tail end). For the schematic diagram showing the connection of a backboard inserted with each rectifier, please see Fig. 7. Two RJ45 connectors are required. The two wires of the CAN bus (CAN-H and CAN-L) are directly short circuited at the backboard. One wire of the SVB (SVB-G) is also directly short circuited, and the required precise divider resistors are connected in series in the other wire (SVB-V), wherein there are 10 precise divider resistors Rv in total with the resistance value of 100 KΩ. One wire of the SRB (SRB-B) is also short circuited, and a carefully selected sequence of precision resistors, for example, from R1, R2, ..., to R8, are connected in series one by one in the other wire (SRB-A), wherein the resistance values of the 8 precision resistors are set to be 8 engineering values of 0.75 KΩ, 1.5 KΩ, 3 KΩ, 6 KΩ, 12 KΩ, 24 KΩ, 50 KΩ and 100 KΩ. Similar change should also be made to the backboard of the monitor unit. For the topology diagram of the in-place and address sequence identification of rectifiers in the embodiments of the present invention, please see Fig. 8.

Regarding the modification of the rectifier circuit, a voltage detection circuit is added to detect the voltage amplitude on the SVB-V wire. The detection circuit can be deployed into the A/D detection circuit of the rectifier *per se* after being regulated by an operational amplifier.

Regarding the modification of the monitor unit circuit, a voltage detection circuit is added to the monitor unit to detect the voltage amplitude on the SVB-V wire. The detection circuit can be deployed into the A/D detection circuit of the monitor unit *per se* after being regulated by an operational amplifier. A resistance measurement circuit with a measurement full scale is 200 KΩ is added to the monitor unit, so as to measure the total impedance between the two wires of the SRB. There are many circuits commonly used for resistance measurement, for example, conversion measurement method (I-V), bridge method, ratio method, etc.

When the monitor unit monitors or the rectifier identifies that there is rectifier address collision on the CAN bus, or there is a new rectifier inserted into socket, or at any necessary moment, the flow of reconfiguring the addresses of the rectifiers can be started. The specific software implementation is described as follows.

The monitor unit sends a broadcast command via the CAN bus to inform all the rectifiers of the amount of the rectifiers N (i.e. 8) configured in the current system, and the current voltage value $V_0$ of the busbar (it is assumed to be 53.5 V) and to require the output voltage of all the rectifiers to maintain stable.

Respective rectifiers detect the voltage value Vr on the corresponding Rv on the SVB through the voltage detection circuit.

The monitor unit also detects the voltage value Vc on the corresponding resistance Rv on the SVB through the voltage detection circuit. The Vc herein is detected only to check the correctness of the value N, as shown in Fig. 1, Vc = $V_0$/(N + 2); apparently, the detected Vc ought to be about 5.35V

Each rectifier determines a socket number thereof by calculating the ratio of the voltage on the SVB to that on the busbar. As shown in Fig. 1, the socket number = Vr × (N + 2)/$V_0$ - 1.

Each rectifier informs the monitor unit of the detected Vr voltage and the calculated socket number. After having checked that there is no error, the monitor unit notifies each rectifier to configure the address number thereof to be consistent with the socket number, so as to implement the sequential configuration and identification of the addresses.

When the monitor unit is power-on, the in-place signals of all the rectifiers can be identified at any time, no matter whether these rectifiers are power-on or in operation. The specific software implementation is described as follows.

The monitor unit detects the total impedance Rt between SRB buses through the resistance value detection circuit.

The monitor unit compares the resistors on the SRB one by one in a descending order, i.e. starting from R8 to R1, according to the detected total impedance, so as to determine which resister(s) among R1~R8 exists, that is, to verify which resistance values among R1~RN is the Rt accumulated from.

Due to the measurement error, there is little chance that Rt is equal to the cumulative sum of the resistance values among R1~R8 completely, therefore, during comparison, the minimum error should be considered.

Once it is determined which resistance values among R1~RN is the Rt accumulated from, it can be identified that these resistors are not short circuited, representing that the rectifiers at the corresponding sockets are not in place, while other rectifiers are in place.

An example is taken for description: assuming that the detected total impedance Rt is 142.5 KΩ, and the comparison precision value is 400 Ω, then the following result can be obtained by comparing Rt with R1~R8 in a descending order (0.75 KΩ, 1.5 KΩ, 3 KΩ, 6 KΩ, 12 KΩ, 24 KΩ, 50 KΩ and 100 KΩ):

$$142.5 \ K\Omega > (100 \ K\Omega - 0.4 \ K\Omega),$$

then R8 is effective;

$$(142.5-100) \ K\Omega = 42.5 \ K\Omega < (50 \ K\Omega - 0.4 \ K\Omega),$$

then R7 is ineffective;

$$42.5 \ K\Omega > (24 \ K\Omega - 0.4 \ K\Omega),$$

then R6 is effective;

$$(42.5 - 24) \ K\Omega = 18.5 \ K\Omega > (12 \ K\Omega - 0.4 \ K\Omega),$$

then R5 is effective;

$$(18.5-12) \ K\Omega = 6.5 \ K\Omega > (6 \ K\Omega - 0.4 \ K\Omega),$$

then R4 is effective;

$$(6.5 - 6) \ K\Omega = 0.5 \ K\Omega < (3 \ K\Omega - 0.4 \ K\Omega),$$

then R3 is ineffective;

$$(6.5 - 6) \ K\Omega = 0.5 \ K\Omega < (1.5 \ K\Omega - 0.4 \ K\Omega),$$

then R2 is ineffective;

$$(6.5 - 6) \ K\Omega = 0.5 \ K\Omega > (0.75 \ K\Omega - 0.4 \ K\Omega),$$

then R1 is effective.

Therefore, the final result is 142.5 K$\Omega \approx$ 100 K$\Omega$ + 24 K$\Omega$ + 12 K$\Omega$ + 6 K$\Omega$ + 0.75 K$\Omega$; in other words, R8/R6/R5/R4/R1 are effective, which represents that: sockets 2, 3 and 7 are inserted with rectifiers, and only the 3 rectifiers are currently configured in the system.

Apparently, due to the error of the detection circuits and the precision resistors, the amount of the rectifiers to be detected is limited, which is equal to 8 (relatively speaking, because the address signal of a rectifier is obtained by the same resistors dividing the voltage, the amount of rectifier addresses that can be detected is more than 200, which is far more than actual requirement, so little consideration is required regarding the limitation on the amount) in this embodiment, it is required to consider how to extend the amount of the rectifiers in a power supply system configured with more than 8 rectifiers. The simplest way is to extend more SRB buses, which is described as follows by taking examples.

Embodiment 2

It is assumed that a certain base station power supply system produced by the company can be configured with 30 rectifiers at most. Apparently, since each pair of SRB buses can only detect 8 rectifiers in the embodiment, 4 pairs of SRB buses are required to be configured, providing the detection capability of at most 32 rectifiers. As shown in Fig. 6, since wires are used in common, only 5 SRB wires in total are required. Apart from these, 2 CAN communication wires are required, and one wire is required for the SVB (the SVB-G can use the direct current negative bar), therefore, during hardware implementation, only 8 wires are required in total, and the Ethernet wire T568A/B (containing 4 twisted pairs marked by colours) of 10/100 BASE-T can still be used, and the connector is a standard RJ45.

In the monitor unit, a plurality of resistance measurement circuits needs to be added or the method of multi-path switching needs to be adopted. The steps executed by the monitoring software are described as follows.

The impedance between SRB-1 and SRB-2 is measured to determine the resistor distribution among R1~R8.

The impedance between SRB-2 and SRB-3 is measured to determine the resistor distribution among R9~R16.

The impedance between SRB-3 and SRB-4 is measured to determine the resistor distribution among R17~R24.

The impedance between SRB-4 and SRB-5 is measured to determine the resistor distribution among R25~R32.

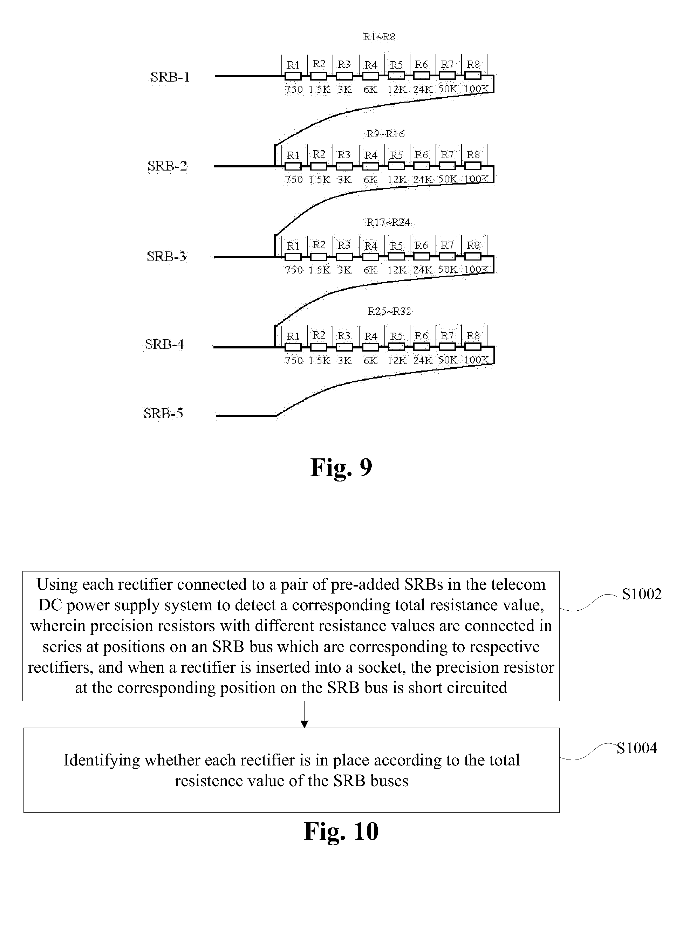

In this way, whether number 1~30 sockets are configured with a rectifier, that is, the in-place signals of more than 30 (at most 32) rectifiers are identified. For the topology diagram of the in-place identification of the rectifiers, please see Fig. 9.

It can be seen from the above-mentioned 2 embodiments that, the method can solve the problem of automatic sequential identification of the addresses of the rectifiers in a master-slave field bus. At the same time, the intelligentized management of the network by the monitor is improved and the workload for product maintenance is greatly reduced because the rectifiers can be positioned very fast according to the addresses thereof. The method can solve the above-mentioned problem and accomplish the identification of the in-place signal of each rectifier, by series wiring of the precision resistors without adding many transmission signal wires and much hardware. The reconfiguration and identification of the addresses can better realize the perfect match of the address and the socket of the device, ensuring the normal communication of the field bus, reducing the workload for product maintenance, and at the same time, improving the intelligentized management to the network by the monitor.

Based on the same inventive concept, an embodiment of the present invention also provides a rectifier identification method. The processing flow of the rectifier identification method is as shown in Fig. 10 and includes:

step S1002, each rectifier connected to a pair of pre-added SRBs in a telecom DC power supply system is used to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and step S1004, it is identified whether each rectifier is in place according to the total resistance value of the SRB buses.

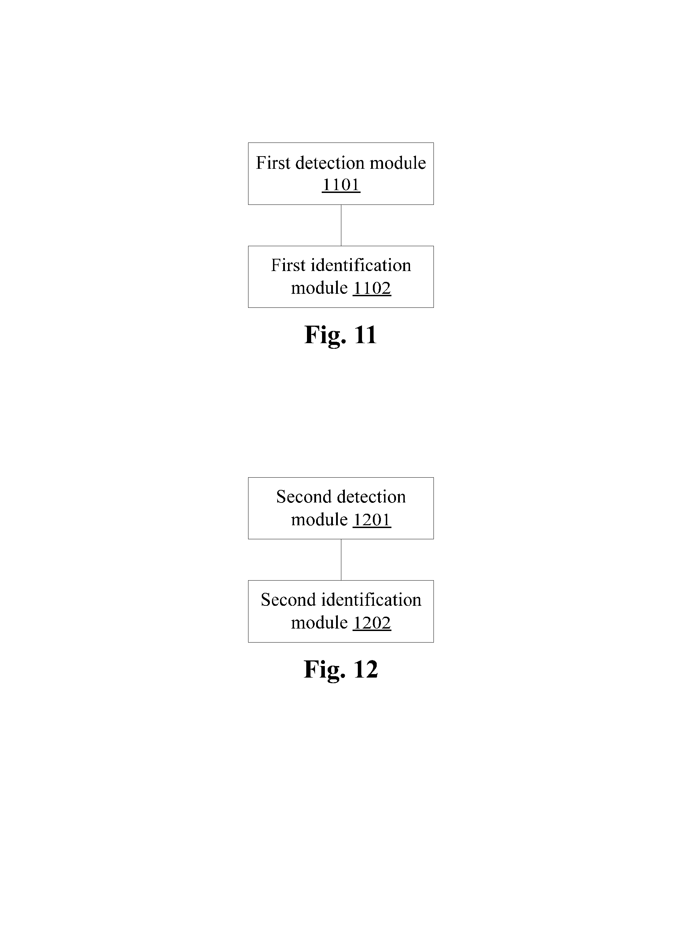

Based on the same inventive concept, an embodiment of the present invention provides a rectifier identification device. The structural schematic diagram is as shown in Fig. 11, and the rectifier identification device includes:

a first detection module 1102, configured to configured to use each rectifier connected to a pair of pre-added socket voltage buses (SVBs) in a telecom direct current (DC) power supply system to detect a corresponding voltage value, wherein precision resistors with same resistance value are connected in series at positions on an SVB bus which are corresponding to respective rectifiers, and two ends of the pair of SVB buses are respectively connected to positive and negative bars of DC output; and a first identification module 1104, connected to the first detection module 1102, configured to identify a position of each rectifier according to the voltage value detected by the each rectifier.

Based on the same inventive concept, an embodiment of the present invention provides a rectifier identification device. The structural schematic structure is as shown in Fig. 12, and rectifier identification device includes:

a second detection module 1202, configured to use each rectifier connected to a pair of pre-added socket resistance buses (SRBs) in a telecom direct current (DC) power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and a second identification module 1204, connected to the second detection module 1202, configured to identify whether each rectifier is in place according to the total resistance value of the SRB buses.

It can be seen from above description that the present invention achieves the following technical effects.

In the embodiment of the present invention, each rectifier connected to the pre-added SVB buses is used to detect a corresponding voltage value, and the position of each rectifier is identified according to the voltage value. Due to the voltage drops at different sockets, different rectifiers can detect different unique voltage amplitudes, based on which the position of each rectifier can be identified and the address information of each rectifier can be acquired. By means of the method provided in the embodiments of the present invention, there is no need to add a chip selection signal wire to each rectifier, and only one pair of SVB buses is added when there are a large amount of rectifiers, without occupying large space, and saving the resources.

Obviously, those skilled in the art should know that each of the mentioned modules or steps of the present invention can be realized by universal computing devices; the modules or steps can be focused on single computing device, or distributed on the network formed by multiple computing devices; selectively, they can be realized by the program codes which can be executed by the computing device; thereby, the modules or steps can be stored in the storage device and executed by the computing device; and under some circumstances, the shown or described steps can be executed in different orders, or can be independently manufactured as each integrated circuit module, or multiple modules or steps thereof can be manufactured to be single integrated circuit module, thus to be realized. In this way, the present invention is not restricted to any particular hardware and software combination.

The descriptions above are only the preferable embodiment of the present invention, which are not used to restrict the present invention, for those skilled in the art, the present invention may have various changes and variations. Any amendments, equivalent substitutions, improvements, etc. within the principle of the present invention are all included in the scope of the protection of the present invention.

**Claims**

1. A rectifier identification method, **characterized by** comprising:

   using each rectifier connected to a pair of pre-added socket voltage buses (SVBs) in a telecom direct current (DC) power supply system to detect a corresponding voltage value, wherein precision resistors with same resistance value are connected in series at positions on an SVB bus which are corresponding to respective rectifiers, and two ends of the pair of SVB buses are respectively connected to positive and negative bars of DC output; and
   identifying a position of each rectifier according to the voltage value detected by the each rectifier.

2. The method according to claim 1, **characterized in that** the pair of SVB buses is respectively defined as a public ground wire (SVB-G) and a voltage signal wire (SVB-V), wherein:

   the precision resistors with the same resistance value are connected in series at positions on the SVB-V which are corresponding to the respective rectifiers; and
   a busbar voltage is loaded on the SVB-V to form a loop via the series connected resistor array, generating an equal voltage drop.

3. The method according to claim 1 or 2, **characterized in that** the voltage value detected by each rectifier is calculated according to the following formula:

   the voltage value detected on the Nth rectifier is: $(M-1)*V_0/M$;
   where M is an actual number of the resistors connected in series, and $V_0$ is the busbar voltage.

4. The method according to claim 1, **characterized by** further comprising:

   using each rectifier connected to a pair of pre-added socket resistance buses (SRBs) in the telecom DC power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and
   identifying whether each rectifier is in place according to the total resistance value of the SRB buses.

5. The method according to claim 4, **characterized in that** the pair of SRB buses is respectively defined as an A wire (SRB-A) and a B wire (SRB-B), wherein:

   the precision resistors with different resistance values are connected in series at positions on the SRB-A which are corresponding to respective rectifiers; and
   the SRB-B is a terminal wire leading out from the resistor, which is located on the SRB-A at the corresponding position of the rectifier furthest from an end where a monitor is located.

6. The method according to claim 4 or 5, **characterized in that** identifying whether each rectifier is in place according to the total resistance value of the SRB buses comprises:

   determining an existing or effective resistor by comparing single resistors on the SRB bus one by one in sequence according to the actual impedance on the SRB bus, wherein the actual impedance of the resistors is the cumulative sum of respective existing or effective single resistors; and

if a single resistor is determined to exist or to be effective, determining that the rectifier corresponding to the single resistor is not in place.

7. The method according to claim 4 or 5, **characterized in that** a maximum detection deviation between each two precision resistors with different resistance values is calculated according to the following formula:

$$\angle Rt = Rt \times (1 + P_R) \times (1 + P_{ADC}) - Rt;$$

where $\Delta Rt$ is the maximum detection deviation between each two precision resistors with different resistance values, Rt is a maximum impedance of a current resistor network, $P_R$ is precision of the used precision resistors, and $P_{ADC}$ is detection precision of an analogue-to-digital converter (ADC) adopted in a precision resistor and resistance value detection circuit.

8. The method according to claim 7, **characterized in that** a minimum resistance value of the precision resistors with different resistance values satisfies the following formula:

$$Rt \times (1 - P_R) > (Rt - R1) \times (1 + P_R) + Rmax \times P_{ADC};$$

where Rmax is a full scale of the current resistor network.

9. A rectifier identification method, **characterized by** comprising:

using each rectifier connected to a pair of pre-added socket resistance buses (SRBs) in a telecom direct current (DC) power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and
identifying whether each rectifier is in place according to the total resistance value of the SRB buses.

10. A rectifier identification device, **characterized by** comprising:

a first detection module, configured to use each rectifier connected to a pair of pre-added socket voltage buses (SVBs) in a telecom direct current (DC) power supply system to detect a corresponding voltage value, wherein precision resistors with same resistance value are connected in series at positions on an SVB bus which are corresponding to respective rectifiers, and two ends of the pair of SVB buses are respectively connected to positive and negative bars of DC output; and
a first identification module, configured to identify a position of each rectifier according to the voltage value detected by the each rectifier.

11. A rectifier identification device, **characterized by** comprising:

a second detection module, configured to use each rectifier connected to a pair of pre-added socket resistance buses (SRBs) in a telecom direct current (DC) power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited; and
a second identification module, configured to identify whether each rectifier is in place according to the total resistance value of the SRB buses.

Using each rectifier connected to a pair of pre-added SVBs in a telecom DC power supply system to detect a corresponding voltage value, wherein precision resistors with same resistance value are connected in series at positions on an SVB bus which are corresponding to respective rectifiers, and two ends of the pair of SVB buses are respectively connected to positive and negative bars of DC output — S 102

Identifying a position of each rectifier according to the voltage value detected by the each rectifier — S 104

## Fig. 1

Using each rectifier connected to a pair of pre-added SRBs in the telecom DC power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited — S 202

Identifying whether each rectifier is in place according to the total resistance value of the SRB buses — S 204

## Fig. 2

```
                        ┌─────────────────┐
                        │      Start      │
                        └─────────────────┘
                                 │
                                 ▼
              ┌─────────────────────────────┐
              │ Two pairs of wires are      │  S302
              │ added to serve as SVB       │
              │ and SRB buses               │
              └─────────────────────────────┘
                                 │
                                 ▼
              ┌─────────────────────────────┐
              │ The precision resistors     │  S304
              │ Rv with the same            │
              │ resistance value are        │
              │ connected in series in      │
              │ SVB-V of the SVB bus        │
              └─────────────────────────────┘
                                 │
                                 ▼
              ┌─────────────────────────────┐        ┌─────────────────────────────┐
              │ Resistors of different      │  S306  │ The monitor unit and the     │  S316
              │ resistance values Rm        │        │ rectifier identify the socket│
              │ (m ranges from 1 to N)      │        │ signal of the rectifier      │
              │ are connected in series     │        │ through the voltage value    │
              │ in the SRB-A of the         │        │ across the SVBs              │
              │ SRB bus                     │        └─────────────────────────────┘
              └─────────────────────────────┘                        │
                                 │                                    ▼
                                 ▼                  ┌─────────────────────────────┐
              ┌─────────────────────────────┐       │ The monitor unit identifies  │  S318
              │ The rectifier is added      │  S308  │ the in-place signal of the   │
              │ with a detection circuit    │        │ rectifier through the        │
              │ for detecting an Rv         │        │ resistance value detected    │
              │ voltage on the SVB          │        │ between the SRB               │
              └─────────────────────────────┘        └─────────────────────────────┘
                                 │                                    │
                                 ▼                                    ▼
              ┌─────────────────────────────┐       ┌─────────────────────────────┐
              │ The monitor unit is         │  S310  │ The rectifier sets the local │  S320
              │ added with a voltage        │        │ address to be the socket     │
              │ detection circuit for       │        │ number                       │
              │ detecting the Rv voltage    │        └─────────────────────────────┘
              │ on the SVB                  │                        │
              └─────────────────────────────┘                        ▼
                                 │                          ┌───────────────┐
                                 ▼                          │      End      │
              ┌─────────────────────────────┐               └───────────────┘
              │ The monitor unit is         │  S312
              │ added with a circuit for    │
              │ detecting impedance         │
              │ between SRBs                 │
              └─────────────────────────────┘
                                 │
                                 ▼
              ┌─────────────────────────────┐
              │ The monitor unit            │  S314
              │ and the rectifiers are      │
              │ started                     │
              └─────────────────────────────┘
```

**Fig. 3**

```
                        ┌──────────────────────┐
                        │        Start          │
                        └──────────────────────┘
                                   │
                                   ▼
                        ┌──────────────────────┐
                        │ The monitor unit is started │ ─── S402
                        └──────────────────────┘
                                   │
                                   ▼
                        ┌──────────────────────┐
                        │ The monitor unit detects the impedance │ ─── S404
                        │      between two SRB wires             │
                        └──────────────────────┘
                                   │
                                   ▼
                        ┌──────────────────────┐
                        │ Each resistor is compared in turn in a │ ─── S406
                        │ descending order of the resistance value, │
                        │ and it is judged which effective resistors │
                        │ are the total impedance accumulated from │
                        └──────────────────────┘
                                   │
                                   ▼
                        ┌──────────────────────┐
                        │ All the effective resistors are determined │ ─── S408
                        └──────────────────────┘
                                   │
                                   ▼
                        ┌──────────────────────┐
                        │ It is determined that the sockets │ ─── S410
                        │ corresponding to all the effective resistors │
                        │ are empty, i.e., rectifiers do not exist on │
                        │             these sockets              │
                        └──────────────────────┘
                                   │
                                   ▼
                        ┌──────────────────────┐
                        │ The monitor unit learns the in-place signal │ ─── S412
                        │        of all the rectifiers           │
                        └──────────────────────┘
                                   │
                                   ▼
                        ┌──────────────────────┐
                        │          End           │
                        └──────────────────────┘
```

**Fig. 4**

Start

The monitor unit and
the rectifiers are started — S502

The monitor unit notifies all the
rectifiers of the maximum
capacity N of the current
configuration via broadcast — S504

The monitor unit detects the
busbar voltage $V_0$, and notifies
all the rectifiers of this busbar
voltage $V_0$ via broadcast — S506

Respective rectifiers detect the
voltage values on the SVB — S508

Each rectifier judges the
proportional relation between the
voltage on the SVB and $V_0$, to
obtain the socket value — S510

Each rectifier sets its address to
be the socket number, and
informs the monitor unit and
other rectifiers of this address — S512

End

**Fig. 5**

DC positive bar  DC negative bar

Rectifier-N — Volt detection — Rv

$R_N$

Communication bus

Rectifier-M — Volt detection — Rv

$R_M$

Communication bus

Rv

Rectifier-2 — Volt detection — Rv

R2

Communication bus

Rectifier-1 — Volt detection — Rv

R1

Communication bus

Monitor unit — Volt detection — Rv

— Rt detection

Communication bus

Rv

SRB bus

Communication bus

SVB bus

**Fig. 6**

**Fig. 7**

**Fig. 8**

R1~R8

| | R1 | R2 | R3 | R4 | R5 | R6 | R7 | R8 | |
SRB-1

750  1.5K  3K  6K  12K  24K  50K  100K

R9~R16

| | R1 | R2 | R3 | R4 | R5 | R6 | R7 | R8 | |
SRB-2

750  1.5K  3K  6K  12K  24K  50K  100K

R17~R24

| | R1 | R2 | R3 | R4 | R5 | R6 | R7 | R8 | |
SRB-3

750  1.5K  3K  6K  12K  24K  50K  100K

R25~R32

| | R1 | R2 | R3 | R4 | R5 | R6 | R7 | R8 | |
SRB-4

750  1.5K  3K  6K  12K  24K  50K  100K

SRB-5

**Fig. 9**

| Using each rectifier connected to a pair of pre-added SRBs in the telecom DC power supply system to detect a corresponding total resistance value, wherein precision resistors with different resistance values are connected in series at positions on an SRB bus which are corresponding to respective rectifiers, and when a rectifier is inserted into a socket, the precision resistor at the corresponding position on the SRB bus is short circuited | S1002 |

| Identifying whether each rectifier is in place according to the total resistence value of the SRB buses | S1004 |

**Fig. 10**

First detection module
1101

First identification
module 1102

**Fig. 11**

Second detection
module 1201

Second identification
module 1202

**Fig. 12**

# INTERNATIONAL SEARCH REPORT

| International application No. |
| --- |
| **PCT/CN2012/078721** |

## A. CLASSIFICATION OF SUBJECT MATTER

See the extra sheet

According to International Patent Classification (IPC) or to both national classification and IPC

## B. FIELDS SEARCHED

Minimum documentation searched (classification system followed by classification symbols)

IPC:H04B 1/-;G01R 19/-;G01R 31/-;G01R 27/-

Documentation searched other than minimum documentation to the extent that such documents are included in the fields searched

Electronic data base consulted during the international search (name of data base and, where practicable, search terms used)

DWPI,CNABS, rectifier, recogni+, identif+, address+, locat+, position+, accurate, precis+, resistance?, resistor?,bus

## C. DOCUMENTS CONSIDERED TO BE RELEVANT

| Category* | Citation of document, with indication, where appropriate, of the relevant passages | Relevant to claim No. |
| --- | --- | --- |
| A | CN 101656549A (ZTE CORP) 24 February 2010 (24.02.2010) description, page 5, the last paragraph to page 6, paragraph[0001], figure 1 | 1-11 |
| A | CN 101509941A (ZTE CORP) 19 August 2009(19.08.2009) the whole document | 1-11 |
| A | US 4090116 A (GENERAL ELECTRIC COMPANY) 16 May 1978 (16.05.1978) the whole document | 1-11 |

☐ Further documents are listed in the continuation of Box C.     ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
| --- | --- |
| 28 September 2012 (28.09.2012) | 25 October 2012 (25.10.2012) |

| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br><br>MA, Yujie<br><br>Telephone No. (86-10) 62414151 |
| --- | --- |

Form PCT/ISA /210 (second sheet) (July 2009)

**INTERNATIONAL SEARCH REPORT**
Information on patent family members

International application No.

**PCT/CN2012/078721**

| Patent Documents referred in the Report | Publication Date | Patent Family | Publication Date |
|---|---|---|---|
| CN 101656549 A | 24.02.2010 | WO 2011026337 A1 | 10.03.2011 |
| | | EP 2472939 A1 | 04.07.2012 |
| CN 101509941 A | 19.08.2009 | None | |
| US 4090116 A | 16.05.1978 | BR 7708065 A | 05.09.1978 |
| | | GB 1598918 A | 23.09.1981 |
| | | CH 632615 A5 | 15.10.1982 |
| | | GB 1598919 A | 23.09.1981 |
| | | SE 7713971 A | 16.10.1978 |
| | | IT 1089072 B | 10.06.1985 |
| | | US 4201936 A | 06.05.1980 |
| | | DE 2747476 A1 | 15.06.1978 |
| | | CA 1102408 A1 | 02.06.1981 |
| | | FR 2392534 A1 | 26.01.1979 |
| | | CA 1089008 A1 | 04.11.1980 |

Form PCT/ISA /210 (patent family annex) (July 2009)

## INTERNATIONAL SEARCH REPORT

International application No.

**PCT/CN2012/078721**

**A.   CLASSIFICATION OF SUBJECT MATTER**

G01R 19/00 (2006.01) i
G01R 27/02 (2006.01) i
G01R 31/00 (2006.01) i-

Form PCT/ISA /210 (extra sheet) (July 2009)